(19) Europäisches Patentamt / European Patent Office / Office européen des brevets

(11) **EP 4 394 815 A1**

(12) **EUROPEAN PATENT APPLICATION**
published in accordance with Art. 153(4) EPC

(43) Date of publication:
**03.07.2024 Bulletin 2024/27**

(21) Application number: **22859546.8**

(22) Date of filing: **07.04.2022**

(51) International Patent Classification (IPC):
**H01F 27/00** (2006.01)

(52) Cooperative Patent Classification (CPC):
**H01F 27/00**

(86) International application number:
**PCT/JP2022/017216**

(87) International publication number:
**WO 2023/026578 (02.03.2023 Gazette 2023/09)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **23.08.2021 JP 2021135779**

(71) Applicant: **Hitachi Industrial Equipment Systems
Co., Ltd.
Tokyo 101-0021 (JP)**

(72) Inventors:
• **IWASAKI, Takuya**
  **Tokyo 101-0021 (JP)**
• **MINAGAWA, Haruki**
  **Tokyo 101-0021 (JP)**
• **YAMAGISHI, Akira**
  **Tokyo 101-0021 (JP)**
• **SUGITA, Ryosuke**
  **Tokyo 101-0021 (JP)**

(74) Representative: **MERH-IP Matias Erny Reichl
Hoffmann
Patentanwälte PartG mbB
Paul-Heyse-Strasse 29
80336 München (DE)**

(54) **DIAGNOSTIC SYSTEM FOR TRANSFORMER**

(57) A transformer diagnostic system having an insulating oil and a winding comprising a detection part detects a temperature at the top and bottom of the insulating oil and hydrogen, an arithmetic unit determines abnormality based on the detected values from the detection part.

Fig.1

**Description**

TECHNICAL FIELD

This invention relates to a transformer diagnostic system.

BACKGROUND ART

As a technique for diagnosing transformer anomalies, patent document1 uses a temperature sensor at the bottom and moisture content to estimate the degree of polymerization.
The patent document2 monitors the load factor and other temperature information without incorporating it by means of upper and lower temperature sensors.
The patent document3 diagnoses deterioration by temperature rise.

CITATION LIST

PATENT DOCUMENT

[patent document1] Japanese unexamined patent publication Tokkai2019-102694
[patent document2] Japanese unexamined patent publication Tokkaihei5-283240
[Patent document3] Japanese unexamined patent publication Tokkai2006-24800

SUMMARY OF THE INVENTION

PROBLEMS TO BE SOLVED BY THE INVENTION

Since the amount of moisture in oil can vary depending on its temperature, if the moisture content is measured at the bottom of the transformer, the moisture content will be lower than during operation, and the error in the degree of polymerization estimation value may be larger. In patent document1, where the degree of polymerization is estimated by the temperature sensor at the bottom and the moisture content, the error in the estimated degree of polymerization value may become larger.
There is a time constant between the winding and the oil, and that time constant varies depending on the oil type and winding structure. The temperature rise of the winding is key in considering damage to the insulation paper, and the monitoring of abnormal diagnosis is insufficient in patent document2, which monitors without incorporating the load factor.
Patent documents diagnoses abnormalities mainly by temperature rise, but the parameters that determine the life of the transformer should consider abnormality diagnosis for other factors such as deterioration of insulating oil and the presence or absence of discharge in addition to the deterioration of insulating paper.
The techniques in patent document1, patent document2, and patent documents are not sufficient to diagnose the lifetime of a transformer with high accuracy.
The purpose of this invention is to provide a transformer diagnostic system that enables highly accurate diagnosis.
One example of this invention is a transformer diagnostic system having an insulating oil and a winding comprising a detection part detects a temperature at the top and bottom of the insulating oil and hydrogen, an arithmetic unit determines abnormality based on the detected values from the detection part.

EFFECTS OF THE INVENTION

According to the present invention, it is possible to realize a diagnostic system for transformer that can perform highly accurate diagnosis.

BRIEF DESCRIPTION OF DRAWINGS

[Fig.1] This diagram illustrates the transformer and diagnostic system in example1.

[Fig.2] This figure shows the relationship between winding temperature and oil temperature in example1.
[Fig.3] This diagram illustrates the transformer and diagnostic system in example2.

MODE FOR CARRYING OUT THE INVENTION

The following is an example of the invention, illustrated with drawings.

[Example1]

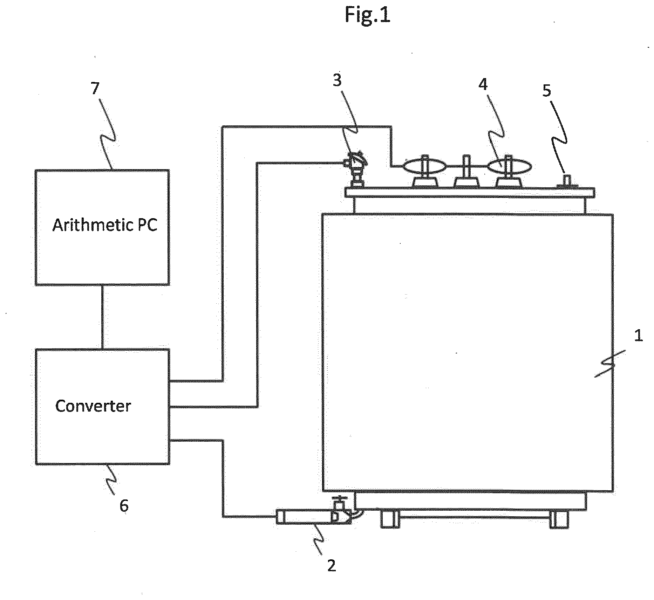

Fig.1 is a configuration diagram illustrating the transformer and diagnostic system in example1.

The transformer1 is an oil-filled transformer with an iron core, a winding attached to the iron core and insulated by insulation paper (winding insulation paper), and insulating oil that soaks the winding and iron core, although the figure is omitted.

Hydrogen detector2 detects hydrogen gas components based on data from a sensor that detects hydrogen gas components in the insulating oil at the bottom of transformer1. Here, it is also the detector that detects the temperature in the lower part of the insulating oil of transformer1. The hydrogen detector and the temperature detector for detecting the temperature at the bottom of the transformer! can be separate sensors.

The temperature detector3 detects temperature based on data from a temperature sensor (such as a resistance thermometer) that detects the temperature at the top of the insulating oil of the transformer1.

The current detector4 detects the load current (secondary current) flowing in the load.

Converter6 performs data conversion of detection data from hydrogen detector2, temperature detectors, and current detector4 for processing on an arithmetic pc (personal computer)7.

The arithmetic PC7 (arithmetic section) is a computer device equipped with a processor (processing unit) such as a CPU, main memory, memory device, communication device, etc., and processes various types of information. The processor (processing unit) of the PC7 executes the operations described below to diagnose abnormalities in the transformer and to predict its service life.

This example transformer diagnostic system comprising a temperature detector2 that detects hydrogen and the temperature of the bottom part of the insulating oil, a detector3 that detects the temperature of the top part of the insulating oil, a current detector (CT)4 that detects the load current (secondary current) flowing in the load, an insulated paper pockets that takes samples of the insulating paper, a converters that converts the data, and an arithmetic PC7 that performs diagnostics and life prediction of the transformer.

The diagnostic system of the transformer in this example measures the maximum winding temperature at the load factor, upper oil temperature, and lower oil temperature, and acquires the temperature history information by wired or wireless communication with an arithmetic PC7. At the same time, the arithmetic PC7 obtains information from the hydrogen sensor and diagnoses abnormalities based on its behavior. The load factor can be calculated from the load current from current detector4. The current to be detected is not limited to the load current, but the load current can be detected from the primary current of the transformer.

The maximum winding temperature $\theta_H$ is defined by the following equation1 (Transformer Reliability Investigation Technical Committee, "Oil-immersed transformer operation guidelines," IEEJ Technical Report (Part 1) No. 143, November 1986, p. 1-2) .
[Number 1]

$$\theta_H = \theta_a + \theta_0 + \theta_g = \theta_a + \theta_0 N \left( \frac{K^2 R + 1}{R + 1} \right)^m + \theta_g N K^{2n} \qquad (1)$$

whereas,

$\theta_H$ : maximum winding temperature (°C)
$\theta_a$ : ambient temperature (°C) (cooling air or cooling water temperature)
$\theta_0 N$: maximum oil temperature rise at rated load (K)
$\theta_g N$: Difference between maximum winding temperature and maximum oil temperature at rated load (K)
K: Ratio of actual load P to rated load PN (in this case, load factor)
R: Ratio of load loss to no load loss at rated load (here R=$W_c$ (load loss)/$W_i$ (no load loss))
m: Constant determined by the cooling method

n: Constant determined by the cooling method

The parameters in equation1 that can be directly measured are $\theta_a$ and K. The parameters that are transformer-specific and can be specified in the shipment are $\theta_0 N$, R, m, and n. Thus, the unknown value is $\theta_g N$, and this estimation technique has been defined in various ways.

Many techniques were employed to estimate using pre-measured values, but in the case of new designs, there was a problem that the previous knowledge was not utilized and differed from the results of the pre-measurement.

In this example, the maximum winding temperature can be estimated with high accuracy in addition to estimation by machine learning by analyzing the parameters attributed to them, in addition to the actual measurement results.

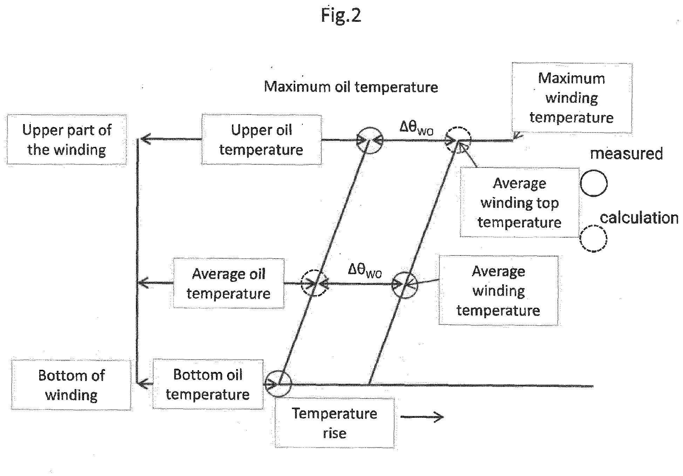

Fig.2 shows the relationship between winding temperature and insulating oil temperature in example1.

The vertical axis in Fig.2 shows the winding height of transformer1, and the horizontal axis shows the temperature rise of transformer1.

The solid circled area indicates the area where the temperature is actually measured. Dotted circles indicate areas where temperatures are calculated from the measured temperatures.

The average winding temperature in Fig.2 can be measured by performing a temperature test before the transformer operation. The maximum oil temperature and the bottom oil temperature can be measured during the operation of the transformer from the temperature detector of the upper insulating oil and the temperature detector of the lower insulating oil, respectively, during operation of the transformer.

The arithmetic PC7 processor calculates the average oil temperature from the measured upper oil temperature, lower (bottom) oil temperature, and the known winding height, and calculates the "average temperature difference between winding and oil" $\Delta\theta_{wo}$ from the difference between the measured average winding temperature and the average oil temperature.

The processing unit of arithmetic PC7 then calculates the "average winding upper temperature" from the measured upper oil temperature(maximum oil temperature) and the "average temperature difference between winding and oil" $\Delta\theta_{wo}$. The "average winding top temperature" can be calculated from the measured temperatures. From information such as the "average winding top temperature" and the measured upper oil temperature(maximum oil temperature), the processing unit of the arithmetic PC7 can accurately estimate the maximum winding temperature.

Until now, the maximum oil temperature of the transformer and the average winding temperature have usually been measured, and the difference between the maximum point oil temperature and the maximum winding temperature was defined as 15°C. Different oil types and designs cause changes in the slope of the winding temperature rise and the slope of the oil temperature rise, resulting in cases where this value cannot be applied as it is.

The processing unit of arithmetic PC7 in this example measures the oil temperature at the top and bottom, calculates the average oil temperature from the winding height information, and takes the difference from the average winding temperature obtained by actual measurement, so that the aforementioned "difference between the maximum winding temperature at rated load and the maximum oil temperature" $\theta_g N$ can be defined based on actual measurement rather than a constant 15°C.

The arithmetic PC7 processor in this example can then calculate the difference $\theta_g N$ between the maximum oil temperature and the maximum winding temperature according to the slope of the winding temperature rise and the slope of the oil temperature rise for different oil types and designs. The maximum winding temperature $\theta_H$ can then be calculated from equation1 with higher accuracy.

Furthermore, the processing unit of arithmetic PC7 in this example uses multiple regression curves to estimate the maximum winding temperature from information on various parameters (oil type, capacity, winding height, number of cooling ducts, wire cross-sectional area, wire shape, loss, etc.) determined during design, actual upper oil temperature and lower (bottom) oil temperature, and average winding temperature, using machine the maximum winding temperature is estimated by machine learning. The estimated maximum winding temperature is reflected in the new design to enable highly accurate life prediction at the design stage.

Using the maximum winding temperature obtained above, the arithmetic PC7 processor in this example predicts the life of the transformer. The life of the transformer is defined as the degradation of the insulation paper and can be approximated by the Arrhenius law using the Montsinger equation within the temperature range of 80°C to 150°C and the following equation2 can be derived by defining it by the.6°C half rule.

[Number 2]

$$\frac{Y}{Y_0} = e^{-0.1155(\theta - 95)} \quad (2)$$

whereas,

$Y_0$: Life expectancy when continuously operated at the highest point temperature of 95°C (25 to 30 years)

Y: Life span when continuously operated at the highest point temperature θ

θ: maximum point temperature θ (can be defined by maximum winding temperature $\theta_H$)

The processing unit of the arithmetic PC7 in this example calculates $Y/Y_0$ according to equation2. Equations allows the remaining life of the transformer to be estimated from the information of the actual thermal history used.

Furthermore, the actual degradation of the insulating paper is also measured by collecting and analyzing a sample of insulating paper from the insulated paper pockets attached to the top of the transformer1 to measure the average degree of polymerization. If the lifetime estimation does not agree with the analysis results, etc., the average degree of polymerization measured is used as the corrected equation2, and the processing unit of the arithmetic PC7 in this example performs the estimation calculation according to the corrected equation: In this way, the system can be doubly monitored by on-line and off-line monitoring. Such a configuration allows a more reliable diagnostic system to be configured.

In this example, a hydrogen detector2 is installed in the lower part of the tank of the transformer! to prevent a serious accident from occurring due to a sudden abnormality such as local heating that is left unnoticed. The processing apparatus of the arithmetic PC7 diagnoses an abnormality of the transformer by determining that the hydrogen component acquired from the hydrogen detector2 exceeds a predetermined value (threshold).

Hydrogen is the cause of all abnormal phenomena and exerts its effects on discharge, heating, and deterioration of insulation paper. In some cases, the degradation of insulation paper can be measured using the moisture content in oil as a proxy, but in this case, if the temperature at the time of collection changes, the saturated moisture content in the oil will differ, and the deposited moisture will migrate to the insulation paper, so there is a risk of misjudging the measurement results. On the other hand, in the case of hydrogen, which is a gas, changes in solubility due to changes in temperature exist, but the changes are several times smaller than those of water content, so the accuracy of analysis is dramatically improved.

The above-mentioned transformer detection data is imported into an arithmetic PC7 through converter6, and various calculations are performed to determine abnormalities in the transformer and to diagnose its remaining life.

According to this example, it is possible to realize a transformer's diagnostic system that can perform highly accurate diagnosis.

[Example2]

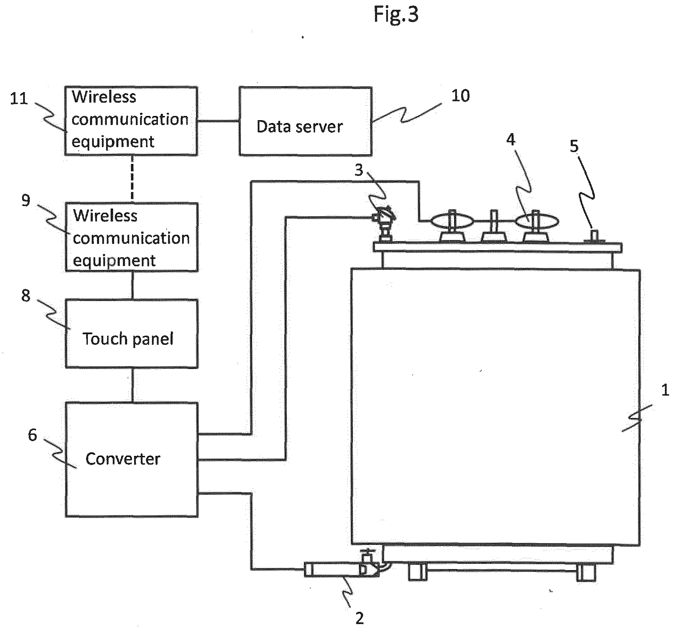

Fig.3 is a configuration diagram illustrating the transformer and diagnostic system in example2.

In example2, the touch panels, first wireless communication equipment9, second wireless communication equipment11, and data server10 are provided. The data server 10 can diagnose the abnormalities of the transformer and predict the service life of the transformer via the first wireless communication equipments and second wireless communication equipment11 without arithmetic PC7 in example1. In this example, detection data such as temperature at the top and bottom of the insulating oil, hydrogen, and load current can be stored in the data server10. Hereinafter, explanations of the same items as in example1 will be omitted.

The touch panels obtains detection data such as temperature at the top and bottom of the insulating oil, hydrogen, and load current via converter6. The user can monitor these detection data with the touch panels.

First wireless communication equipments and second wireless communication equipment11 communicate data between touch panels and data server10.

Based on the detection data from the transformer1 obtained from the second wireless communication equipment11, the data server10 performs the same as the arithmetic PC7 in example! to determine the abnormality of the transformer and to diagnose the remaining life of the transformer.

According to this example, in addition to the effects of .example 1, the detection data of multiple transformers can be stored in data server 10, and the diagnosis of each transformer can be. centrally managed.

REFERENCE SIGNS LIST

1:      transformer
2:      hydrogen detector
3:      temperature detector
4:      current detector

EP 4 394 815 A1

5: insulated paper pocket
6: converter
7: arithmetic PC
8: touch panel
9: first wireless communication equipment
10: data server
11: second wireless communication equipment

**Claims**

1. A transformer diagnostic system having an insulating oil and a winding comprising:

   a detection part detects a temperature at the top and bottom of the insulating oil and hydrogen,
   an arithmetic unit determines abnormality based on the detected valu es from the detection part.

2. A transformer diagnostic system described in claim 1 comprising:

   a current detector detects the load current flowing in the winding,
   the arithmetic unit calculates the load factor from the detected load current value.

3. A transformer diagnostic system described in claim 1 comprising:

   hydrogen and lower oil temperatures are detected in the same detector,
   the arithmetic unit determines an abnormality when the amount of hydrogen detected exceeds a predetermined
   threshold value.

4. A transformer diagnostic system described in claim 1 comprising:

   the arithmetic unit
   calculates average oil temperature from the upper and lower insulating oil,
   calculates the average temperature difference between the winding and the insulating oil from the average
   winding temperature and the average oil temperature,
   calculates the average temperature of the upper part of the winding from the average temperature difference
   and the temperature of upper part of the insulating oil.

5. A transformer diagnostic system described in claim 4 comprising:

   the arithmetic unit calculate a maximum winding temperature,
   estimates the remaining life of the transformer from the calculated maximum winding point temperature.

6. A transformer diagnostic system described in claim 4 comprising:
   the arithmetic unit estimates a maximum winding temperature from the parameter determined at the time of design.

7. A transformer diagnostic system described in claim 1 comprising:

   an insulated paper pocket,
   the arithmetic unit estimates remaining life of the transformer based on the results of analyzing the insulating
   paper collected from the insulating paper pocket.

8. A transformer diagnostic system described in claim 1 comprising:

   an iron core,
   a winding attached to the iron core and insulated by insulating paper,
   and insulating oil for immersing the winding and iron core.

9. A transformer diagnostic system having an insulating oil and a winding comprising:

a communication equipment transmits detected temperature data of the upper and bottom part of the insulating oil and the hydrogen detection data,
a data processing unit receives the detected data from the communication equipment,
the data processing unit diagnoses an abnormality based on the detection data.

Fig.1

## Fig.2

# Fig.3

<div align="center">**INTERNATIONAL SEARCH REPORT**</div>

| International application No. |
|---|
| **PCT/JP2022/017216** |

**A.    CLASSIFICATION OF SUBJECT MATTER**

*H01F 27/00*(2006.01)i
FI:   H01F27/00 B; H01F27/00 H

According to International Patent Classification (IPC) or to both national classification and IPC

**B.    FIELDS SEARCHED**

Minimum documentation searched (classification system followed by classification symbols)

H01F27/00; H01F30/00-38/00; H01F41/00; H02J13/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| Y | JP 2005-73478 A (TM T & D KK) 17 March 2005 (2005-03-17) | 1-3, 7-9 |
| | paragraphs [0039]-[0045], [0064]-[0073], fig. 1, 10, 11 | |
| A | paragraphs [0039]-[0045], [0064]-[0073], fig. 1, 10, 11 | 4-6 |
| Y | JP 2011-171413 A (MITSUBISHI ELECTRIC CORP.) 01 September 2011 (2011-09-01) | 1-3, 7-9 |
| | paragraphs [0019]-[0029], [0055]-[0070], fig. 1-4, 9-12 | |
| A | paragraphs [0019]-[0029], [0055]-[0070], fig. 1-4, 9-12 | 4-6 |
| Y | JP 7-297038 A (HITACHI, LTD.) 10 November 1995 (1995-11-10) | 1-3, 7-9 |
| | paragraphs [0002]-[0004], fig. 3 | |
| Y | JP 58-18909 A (SHIKOKU DENRIYOKU KK) 03 February 1983 (1983-02-03) | 1-3, 7-9 |
| | page 2, lower left column, line 10 to page 2, lower left column, line 5, fig. 1 | |
| Y | JP 2003-289008 A (DAIHEN CORP.) 10 October 2003 (2003-10-10) | 7 |
| | paragraphs [0011]-[0027], fig. 1-3 | |
| A | JP 2006-24800 A (AICHI ELECTRIC CO., LTD.) 26 January 2006 (2006-01-26) | 1-9 |
| | entire text, all drawings | |

☐ Further documents are listed in the continuation of Box C.       ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **20 May 2022** | **07 June 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

## INTERNATIONAL SEARCH REPORT
### Information on patent family members

International application No.

**PCT/JP2022/017216**

| Patent document cited in search report | | | Publication date (day/month/year) | Patent family member(s) | Publication date (day/month/year) |
|---|---|---|---|---|---|
| JP | 2005-73478 | A | 17 March 2005 | (Family: none) | |
| JP | 2011-171413 | A | 01 September 2011 | US 2011/0202288 A1 paragraphs [0033]-[0044], [0070]-[0089], fig. 1-4, 9-12 CN 102162786 A | |
| JP | 7-297038 | A | 10 November 1995 | (Family: none) | |
| JP | 58-18909 | A | 03 February 1983 | US 4502320 A column 3, line 53 to column 4, line 35, fig. 1 GB 2104655 A DE 3227840 A1 | |
| JP | 2003-289008 | A | 10 October 2003 | (Family: none) | |
| JP | 2006-24800 | A | 26 January 2006 | (Family: none) | |

Form PCT/ISA/210 (patent family annex) (January 2015)

**REFERENCES CITED IN THE DESCRIPTION**

**Patent documents cited in the description**

- JP 2019102694 A
- JP 5283240 A

- JP 2006024800 A

**Non-patent literature cited in the description**

- Oil-immersed transformer operation guidelines. *IEEJ Technical Report (Part 1),* November 1986, (143), 1-2